# EUROPEAN PATENT APPLICATION

(11) **EP 4 379 795 A1**
(43) Date of publication of application: **05.06.2024**
(21) Application number: 23211598.0
(22) Date of filing: 22.11.2023
(51) Int. Cl.: H01L 23/48, H01L 23/528

(54) **SEMICONDUCTOR DEVICE HAVING THROUGH-VIA STRUCTURE**

(30) Priority: 29.11.2022 KR 20220163253
(71) Applicant: Samsung Electronics Co., Ltd., Suwon-si, Gyeonggi-do 16677 (KR)
(72) Inventor: KIM, Sunoo, 16677 Suwon-si (KR); DING, Shaofeng, 16677 Suwon-si (KR); AHN, Jeonghoon, 16677 Suwon-si (KR); OH, Jaehee, 16677 Suwon-si (KR)
(74) Representative: Marks & Clerk LLP

(57) **Abstract**

A semiconductor device includes: a semiconductor substrate; an integrated circuit layer disposed on the semiconductor substrate; a first metal wiring layer to an n-th metal wiring layer sequentially disposed on the semiconductor substrate and the integrated circuit layer, wherein n is a positive integer; a plurality of wiring vias connecting the first to n-th metal wiring layers to each other; and a through-via extending in a vertical direction from a via connection pad, which is any one of the first metal wiring layer to the n-th metal wiring layer, toward the semiconductor substrate and penetrating the semiconductor substrate, wherein the via connection pad is a capping-type via connection pad formed on an upper surface of the through-via.

## Description

### TECHNICAL FIELD

The present inventive concept relates to a semiconductor device, and more particularly, to a semiconductor device having a through-via structure.

### DISCUSSION OF THE RELATED ART

As the amount of data to be processed by electronic devices increases, it becomes increasingly desired for semiconductor devices to have a high capacity and a high bandwidth. To this end, a technique of using a through-via, for example, a through-silicon-via (TSV), formed by, for example, drilling a fine hole in a semiconductor device to form a through-electrode has been under development. When a through-via is used as an electrode, it is desirable for resistance between a through-via and a via connection pad (or, e.g., metal wiring layer), which is connected to the through-via, to be reduced.

### SUMMARY

According to an embodiment of the present inventive concept, a semiconductor device includes: a semiconductor substrate; an integrated circuit layer disposed on the semiconductor substrate; a first metal wiring layer to an n-th metal wiring layer sequentially disposed on the semiconductor substrate and the integrated circuit layer, wherein n is a positive integer; a plurality of wiring vias connecting the first to n-th metal wiring layers to each other; and a through-via extending in a vertical direction from a via connection pad, which is any one of the first metal wiring layer to the n-th metal wiring layer, toward the semiconductor substrate and penetrating the semiconductor substrate, wherein the via connection pad is a capping-type via connection pad formed on an upper surface of the through-via.

According to an embodiment of the present inventive concept, a semiconductor device includes: a semiconductor substrate having a first surface and a second surface opposite to the first surface; a front-end level layer including an integrated circuit layer that is disposed on the first surface of the semiconductor substrate; a back-end level layer including a first metal wiring layer to an n-th metal wiring layer and a plurality of wiring vias respectively connecting the first metal wiring layer to the n-th metal wiring layer to each other, wherein n is a positive integer, and the first metal wiring layer to the n-th metal wiring layer are sequentially disposed on the front-end level layer; and a through-via extending in a vertical direction from a via connection pad, which is any one of the first metal wiring layer to the n-th metal wiring layer, toward the semiconductor substrate and penetrating the back-end level layer, the front-end level layer, and the first surface and the second surface of the semiconductor substrate, wherein the via connection pad includes a first capping-type via connection pad and a second capping-type via connection pad, wherein the first capping-type via connection pad is formed on an upper surface of the through-via, and the second capping-type via connection pad is formed on the first capping-type via connection pad and has a width greater than a width of the first capping-type via connection pad.

According to an embodiment of the present inventive concept, a semiconductor device includes: a semiconductor substrate; a front-end level layer including an integrated circuit layer disposed on the semiconductor substrate, an interlayer insulating layer disposed on the integrated circuit layer, and a contact plug and an electrode layer electrically connected to the integrated circuit layer within the interlayer insulating layer; a back-end level layer including a first metal wiring layer to an n-th metal wiring layer, which are electrically connected to the contact plug and the electrode layer, over the front-end level layer, a plurality of wiring insulating layers disposed between the first metal wiring layer to the n-th metal wiring layer, and a plurality of wiring vias disposed between the first metal wiring layer to the n-th metal wiring layers within the wiring insulating layers, wherein n is a positive integer; and a through-via extending in a vertical direction from a via connection pad, which is any one of the first metal wiring layer to the n-th metal wiring layer, toward the semiconductor substrate and penetrating the plurality of wiring insulating layers, the interlayer insulating layer, and the semiconductor substrate, wherein the via connection pad includes a first capping-type via connection pad and a second capping-type via connection pad, wherein the first capping-type via connection pad covers an upper surface of the through-via and has an octagonal shape, and the second capping-type via connection pad is formed on the first capping-type via connection pad and has an octagon shape at least partially surrounding the first capping-type via connection pad.

At least some of the above and other features of the invention are set out in the claims.

### BRIEF DESCRIPTION OF THE DRAWINGS

The above and other aspects of the present inventive concept will become more apparent by describing in detail embodiments thereof, with reference to the accompanying drawings, in which:
FIG. 1 is a cross-sectional view illustrating a semiconductor device according to an embodiment of the present inventive concept;
FIG. 2 is a layout view illustrating a plane level of a via connection pad and a fourth metal wiring layer of FIG. 1;
FIGS. 3 and 4 are cross-sectional views respectively taken along line III-III' and line IV-IV' of FIG. 2;
FIG. 5 is a cross-sectional view illustrating a semiconductor device according to an embodiment of the present inventive concept;
FIG. 6 is a cross-sectional view illustrating a semiconductor device according to an embodiment of the present inventive concept;
FIGS. 7, 8, 9, 10, 11 and 12 are cross-sectional views illustrating a method of manufacturing a semiconductor device, according to an embodiment of the present inventive concept;
FIG. 13 is a block diagram illustrating a configuration of a semiconductor chip including a semiconductor device, according to an embodiment of the present inventive concept;
FIG. 14 is a block diagram illustrating a configuration of a semiconductor chip including a semiconductor device, according to an embodiment of the present inventive concept;
FIG. 15 is a block diagram illustrating a configuration of a semiconductor package including a semiconductor device according to an embodiment of the present inventive concept;
FIG. 16 is a circuit diagram of a static random access memory (SRAM) cell included in a semiconductor device, according to an embodiment of the present inventive concept; and
FIG. 17 is a view illustrating a semiconductor package including a semiconductor device, according to an embodiment of the present inventive concept.

### DETAILED DESCRIPTION OF THE EMBODIMENTS

Hereinafter, embodiments of the present inventive concept will be described with reference to the accompanying drawings. The following embodiments of the present inventive concept may be implemented as only one embodiment, and also, the following embodiments may be implemented in combination of one or more embodiments. Therefore, the present inventive concept should not be construed as being limited to one embodiment.

In the drawings, like reference characters denote like elements, and redundant descriptions thereof may be omitted or briefly discussed.

It is to be understood that singular forms of components may include plural forms unless the context clearly indicates otherwise. In the attached drawings, various thicknesses, lengths, and angles are shown and while the arrangement shown does indeed represent an embodiment of the present inventive concept, it is to be understood that modifications of the various thicknesses, lengths, and angles may be possible within the scope of the present inventive concept, and the present inventive concept is not necessarily limited to the particular thicknesses, lengths, and angles shown.

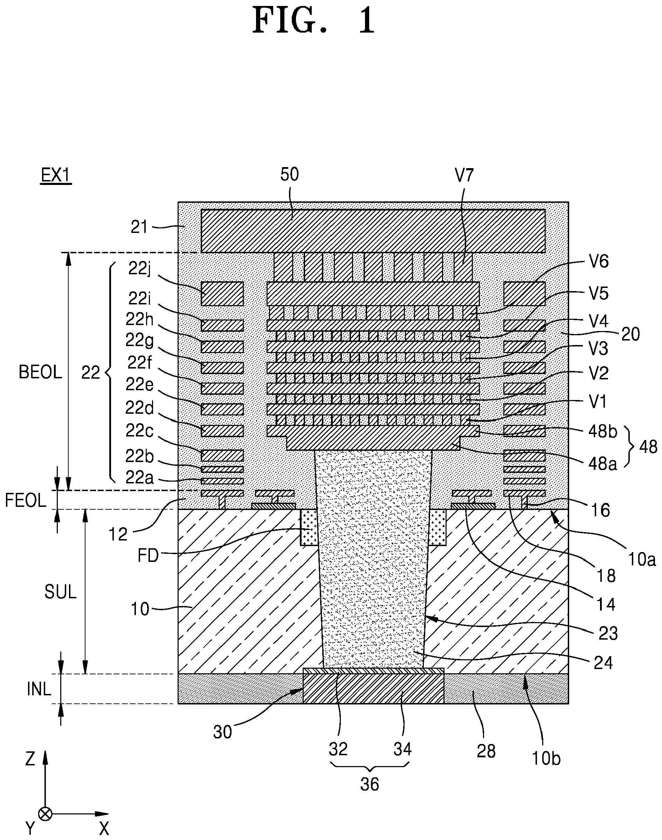

FIG. 1 is a cross-sectional view illustrating a semiconductor device according to an embodiment of the present inventive concept.

For example, a semiconductor device EX1 may include a semiconductor substrate 10. The semiconductor substrate 10 may constitute a substrate level layer SUL. The semiconductor substrate 10 may be composed of a semiconductor wafer. The semiconductor substrate 10 may include a group IV material or a group III-V compound. The semiconductor substrate 10 may be composed of a single crystal wafer, for example, a silicon single crystal wafer.

The semiconductor substrate 10 is not limited to a single crystal wafer and may be composed of any one of various wafers, such as an epi or epitaxial wafer, a polished wafer, an annealed wafer, and a silicon on insulator (SOI) wafer. The epitaxial wafer refers to a wafer in which a crystalline material is grown on a single crystal silicon substrate. For example, the semiconductor substrate 10 may be a silicon substrate. The semiconductor substrate 10 may include a first surface 10a, and a second surface 10b opposite to the first surface 10a.

The semiconductor device EX1 may include an integrated circuit layer 14. The integrated circuit layer 14 may be formed on the first surface 10a of the semiconductor substrate 10. The integrated circuit layer 14 may include circuit elements, such as transistors, capacitors, and/or resistors. The semiconductor device EX1 may function as a memory device or a logic device depending on structures of the integrated circuit layer 14.

For example, the memory device may include dynamic random access memory (DRAM), static RAM (SRAM), flash memory, electrically erasable and programmable read only memory (EEPROM), phase-change RAM (PRAM), magnetic RAM (MRAM), resistance RAM (RRAM), or so on. A structure of the integrated circuit layer 14 is commonly known and does not limit the scope of the present inventive concept.

The semiconductor substrate 10 may include an active region and an inactive region FD. The active region may be limited by the inactive region FD, for example, a trench isolation region. An impurity-doped region, for example, a source and drain region and a well region may be further formed on the first surface 10a of the semiconductor substrate 10.

An interlayer insulating layer 12 may be formed on the semiconductor substrate 10 and the integrated circuit layer 14. The interlayer insulating layer 12 may be formed of silicon oxide. A contact plug 16 and an electrode layer 18, which are electrically connected to the integrated circuit layer 14 and the active region, may be formed in the interlayer insulating layer 12. The contact plug 16 and the electrode layer 18 may be formed of a metal, such as tungsten.

The integrated circuit layer 14, the interlayer insulating layer 12, the contact plug 16, and the electrode layer 18 formed on the semiconductor substrate 10 may constitute a front-end level layer FEOL. In some embodiments of the present inventive concept, the electrode layer 18 may be included in a back-end level layer BEOL to be described below. The front-end level layer FEOL may be referred to as a front end of line in terms of a manufacturing process.

The semiconductor device EX1 may include metal wiring layers 22. The metal wiring layers 22 may be formed of a metal, such as copper, aluminum, or tungsten. The semiconductor device EX1 may include the metal wiring layers 22 sequentially and electrically connected to each other over the semiconductor substrate 10, the integrated circuit layer 14, the contact plug 16, and the electrode layer 18. The metal wiring layers 22 may include a first metal wiring layer 22a to a tenth metal wiring layer 22j. The first metal wiring layer 22a may be the lowermost metal wiring layer. The tenth metal wiring layer 22j may be the uppermost metal wiring layer. A lowermost metal wiring layer may be a metal wiring layer that is closest to the substrate 10 (out of the metal wiring layers 22), and an uppermost metal wiring layer may be a metal wiring layer that is further from the substrate 10 (out of the metal wiring layers 22). The metal wiring layers 22 may extend in a horizontal direction (e.g. a direction parallel to an upper surface of the substrate 10 (e.g. the first surface 10a)). The metal wiring layers 22 may be sequentially arranged in a vertical direction (e.g. a direction perpendicular to the upper surface of the substrate 10 (e.g. the first surface 10a)).

Although FIG. 1 illustrates only the first metal wiring layer 22a to the tenth metal wiring layer 22j for the sake of convenience of illustration, first to n-th (n is a positive integer) metal wiring layers may be sequentially formed over the semiconductor substrate 10, the integrated circuit layer 14, the contact plug 16, and the electrode layer 18. Here, the n-th metal wiring layer may be the uppermost metal wiring layer. In the first to n-th metal wiring layers of some embodiments of the present inventive concept, n may be a positive integer that is less than or equal to 30.

The semiconductor device EX1 may include a wiring insulating layer 20. The wiring insulating layer 20 may insulate between the first metal wiring layer 22a to the tenth metal wiring layer 22j. The wiring insulating layer 20 may be formed of, for example, silicon oxide. The semiconductor device EX may include wiring vias V1 to V7. The wiring vias V1 to V7 may electrically connect the metal wiring layers 22 to each other in the wiring insulating layer 20. Each of the wiring vias V1 to V7 may extend in the vertical direction.

The wiring vias V1 to V7 may be formed of a metal, such as copper, aluminum, or tungsten. The wiring vias V1 to V7 may include a first wiring via V1 to a seventh wiring via V7. Each of the first wiring via V1 to the seventh wiring via V7 may include a plurality of sub wiring vias.

The metal wiring layers 22, the wiring insulating layer 20, and the wiring vias V1 to V7, which are formed on the front-end level layer FEOL, may constitute the back-end level layer BEOL. The back-end level layer BEOL may also be referred to as a back end of line in terms of a manufacturing process.

The semiconductor device EX1 may include a through-via (through-silicon-via) 24. The through-via 24 may be a via electrode for signal transmission or a via electrode for power transmission. The through-via 24 may extend in the vertical direction (e.g., a thickness direction) from a via connection pad 48, which is any one of the first metal wiring layer 22a to the tenth metal wiring layer 22j, toward the semiconductor substrate 10 and may penetrate the semiconductor substrate 10. The via connection pad 48 may be the fourth metal wiring layer 22d.

The via connection pad 48 may be a capping-type via connection pad formed on an upper surface of the through-via 24. For example, the via connection pad 48 may be disposed on an entirety of the upper surface of the through-via 24. The via connection pad 48 may include a first capping-type via connection pad 48a and a second capping-type via connection pad 48b. The first capping-type via connection pad 48a may be formed on the upper surface of the through-via 24, and the second capping-type via connection pad 48b may be formed on the first-capping-type via connection pad 48a. For example, the first capping-type via connection pad 48a may be disposed on an entirety of the upper surface of the through-via 24, and the second capping-type via connection pad 48b may be formed on an entirety of the first-capping-type via connection pad 48a. When viewed from a cross-section, a width (e.g. in a horizontal direction) of the second capping-type via connection pad 48b may be greater than a width (e.g. in a horizontal direction) of the first capping-type via connection pad 48a. The first capping-type via connection pad 48a may be formed of the same body as the second capping-type via connection pad 48b. For example, the first capping-type via connection pad 48a and the second capping-type via connection pad 48b may be a single body.

When the via connection pad 48 is configured to be a capping-type via connection pad, resistance between the via connection pad 48, that is, the fourth metal wiring layer 22d, and the through-via 24 may be reduced. Resistance between the via connection pad 48 of a capping type according to the present inventive concept and the through-via 24 may be reduced by about 20% to 60% compared to a line-shaped or rod-shaped via connection pad formed on only a portion of an upper surface of the through-via 24.

The via connection pad 48 may use the fourth metal wiring layer 22d but may use any one of the first metal wiring layer 22a to the tenth metal wiring layer 22j. The via connection pad 48 may be in an intermediate portion of the first metal wiring layer 22a to the tenth metal wiring layer 22j. The via connection pad 48 is described below in more detail.

The through-via 24 may penetrate the wiring insulating layer 20, which constitutes the back-end level layer BEOL, the interlayer insulating layer 12, which constitutes the front-end level layer FEOL, and the semiconductor substrate 10. A height of the through-via 24 may be several tens of µm, for example, about 50 µm to about 90 µm.

The through-via 24 may be formed inside a through-via hole 23 formed in all of the back-end level layer BEOL, the front-end level layer FEOL, and the semiconductor substrate 10. A via insulating layer may be formed on an inner wall of the through-via hole 23. The through-via 24 may be formed of a metal, such as copper, aluminum, or tungsten.

The semiconductor device EX1 may include an upper pad 50. The upper pad 50 may be formed of a metal, such as copper, aluminum, or tungsten. The upper pad 50 may be insulated by an upper protective insulating layer 21. The upper protective insulating layer 21 may be formed of, for example, silicon oxide. The upper pad 50 may be formed on the back-end level layer BEOL. The upper pad 50 may be electrically connected to the tenth metal wiring layer 22j, which is the uppermost layer among the first metal wiring layer 22a to the tenth metal wiring layer 22j, through the seventh wiring via V7.

Solder bumps, which are external connection terminals, may be further formed on the upper pads 50. Another semiconductor device may be stacked on and bonded to the upper pad 50.

The semiconductor device EX1 may include a lower pad 36. The lower pad 36 may include a barrier metal layer 32 and a pad metal layer 34 disposed in a via exposure hole 30. The barrier metal layer 32 may be formed of, for example, Ta or TiN. The pad metal layer 34 may be formed of, for example, copper, aluminum, or tungsten.

The lower pad 36 may be electrically connected to the through-via 24 on a bottom side of the semiconductor substrate 10. The lower pad 36 may be insulated from the semiconductor substrate 10 by a lower protective insulating layer 28 on the second surface 10b of the semiconductor substrate 10. The lower protective insulating layer 28 may be formed of, for example, silicon oxide.

The lower protective insulating layer 28 may constitute an insulating level layer INL on the second surface 10b of the semiconductor substrate 10. Solder bumps, which are external connection terminals, may be formed on the lower pad 36. Another semiconductor device may be stacked on and bonded to the lower pad 36.

In the semiconductor device EX1 described above, the through-via 24 may be connected to the via connection pad 48 in an intermediate portion of the back-end level layer BEOL. In the semiconductor device EX1, the via connection pad 48 may be configured as a capping-type via connection pad on the upper surface of the through-via 24, and accordingly, resistance between the through-via 24 and the via connection pad 48 (i.e., the fourth metal wiring layer 22d), which is connected to the through-via 24, may be reduced.

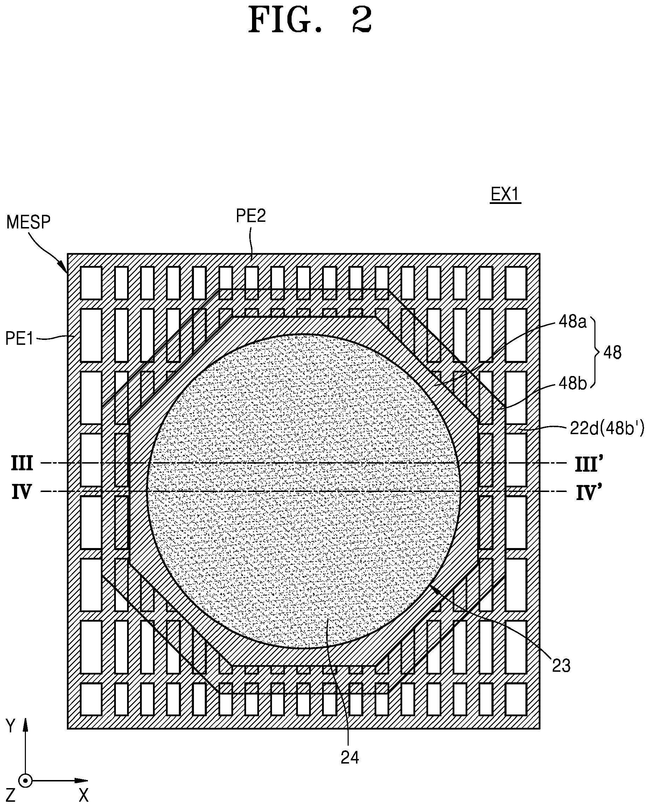

FIG. 2 is a layout diagram illustrating a plane level of the via connection pad 48 and the fourth metal wiring layer 22d of FIG. 1.

For example, FIG. 2 may be a layout view (or a plan view) illustrating an arrangement of the via connection pad 48 and the fourth metal wiring layer 22d of the semiconductor device EX1 in FIG. 1. In FIG. 2, descriptions previously given with reference to FIG. 1 are briefly described or omitted.

The semiconductor device EX1 may include the through-via 24, the via connection pad 48, and the fourth metal wiring layer 22d. The through-via 24 may be inside the through-via hole 23. The through-via 24 may have, for example, a circular shape in a plan view. However, the present inventive concept is not limited thereto.

The via connection pad 48 may include the first capping-type via connection pad 48a and the second capping-type via connection pad 48b. The first capping-type via connection pad 48a may be formed on an upper surface of the through-via 24 in a plan view and may have an octagonal shape at least partially surrounding the through-via 24. For example, the first capping-type via connection pad 48a may be formed on an entirety of the upper surface of the through-via 24 in a plan view. The second capping-type via connection pad 48b may be formed on an upper surface of the first capping-type via connection pad 48a and may have an octagonal shape at least partially surrounding the first capping-type via connection pad 48a in a plan view. For example, the second capping-type via connection pad 48b may be formed on an entirety of the upper surface of the first capping-type via connection pad 48a. The octagonal shape of the first capping-type connection pad 48a may be aligned with the octagonal shape of the second capping-type connection pad 48b (e.g. corresponding edges of the octagonal shapes may be aligned/parallel to each other).

The via connection pad 48 may further include the n-th metal wiring layer, that is, the fourth metal wiring layer 22d, at the same horizontal level as the second capping-type via connection pad 48b among the first metal wiring layer to the n-th (n is a positive integer) metal wiring layer. The fourth metal wiring layer 22d may be an additional second capping-type via connection pad 48b'.

The semiconductor device EX1 may include the n-th metal wiring layer, that is, the fourth metal wiring layer 22d, at the same horizontal level as the via connection pad 48 and around or in the periphery of the via connection pad 48 among the first metal wiring layer to the n-th (n is a positive integer) metal wiring layer.

The fourth metal wiring layer 22d may have a mesh pattern MESP in a plan view. The mesh pattern MESP may include a plurality of first patterns PE1 separated from each other in a first horizontal direction (e.g. an X direction) and a plurality of second patterns PE2 separated from each other in a second horizontal direction (e.g. a Y direction) in a plan view. The first horizontal direction may intersect (e.g. may be perpendicular to) the first horizontal direction. The fourth metal wiring layer 22d having the mesh pattern MESP may be provided to increase polishing uniformity during a chemical mechanical polishing process for forming the fourth metal wiring layer 22d in the manufacturing of the semiconductor device EX1.

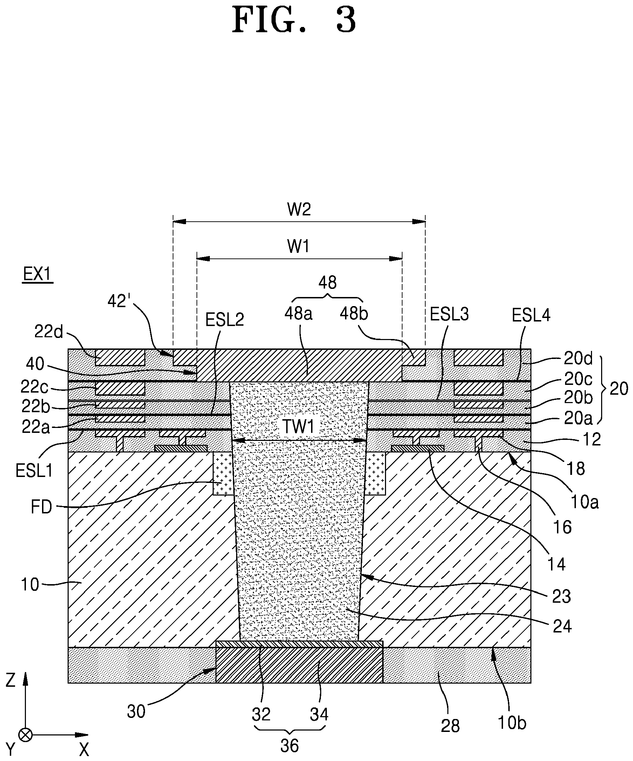

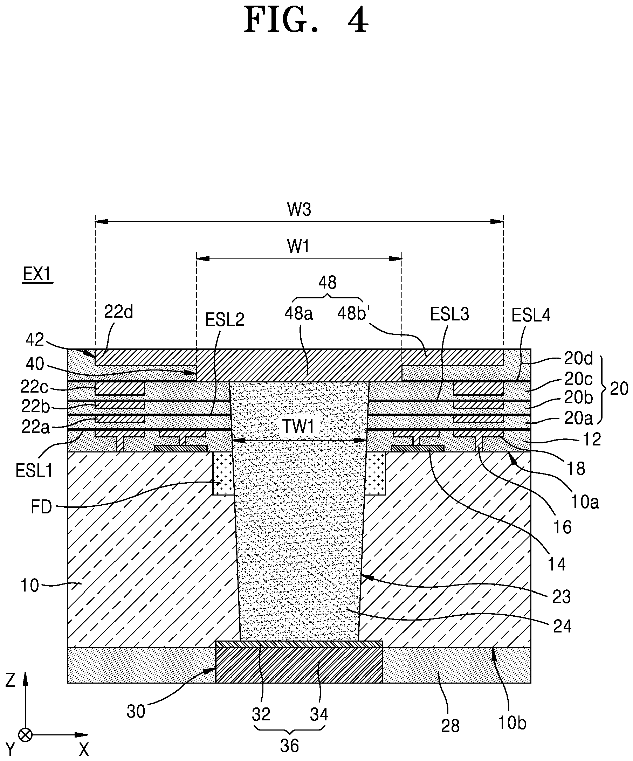

FIGS. 3 and 4 are cross-sectional views respectively taken along line III-III' and line IV-IV' of FIG. 2.

For example, FIG. 3 may be a partially enlarged cross-sectional view of FIG. 1. In FIGS. 3 and 4, descriptions previously given with reference to FIG. 1 are briefly described or omitted. The semiconductor device EX1 may include the semiconductor substrate 10 including the first surface 10a and the second surface 10b opposite to the first surface 10a. The inactive region FD may be formed in the semiconductor substrate 10. The integrated circuit layer 14 may be formed on the first surface 10a of the semiconductor substrate 10.

The interlayer insulating layer 12 may be formed on the semiconductor substrate 10 and the integrated circuit layer 14. The interlayer insulating layer 12 may be formed of, for example, silicon oxide. The contact plug 16 and the electrode layer 18, which are electrically connected to the integrated circuit layer 14 and the active region, may be formed in the interlayer insulating layer 12.

A first etch stop layer ESL1 may be formed on the interlayer insulating layer 12 and the electrode layer 18. The first etch stop layer ESL1 may be formed of, for example, silicon nitride. The first etch stop layer ESL1 might not be formed.

The semiconductor device EX1 may include metal wiring layers 22 in FIG. 1 sequentially stacked on each other and electrically connected to each other over the semiconductor substrate 10, the integrated circuit layer 14, the contact plug 16, and the electrode layer 18. The metal wiring layers 22 in FIG. 1 may include the first metal wiring layer 22a to the fourth metal wiring layer 22d. In an embodiment of the present inventive concept, the metal wiring layers 22 may be electrically connected to the integrated circuit layer 14.

The semiconductor device EX1 may include wiring insulating layers 20. The wiring insulating layers 20 may include a first wiring insulating layer 20a to a fourth wiring insulating layer 20d. The wiring insulating layers 20 may be disposed between the first metal wiring layer 22a to the fourth metal wiring layer 22d. The wiring insulating layers 20 may be formed of, for example, silicon oxide. The first metal wiring layer 22a to the fourth metal wiring layer 22d may be electrically connected to each other.

A second etch stop layer ESL2 may be formed on the first wiring insulating layer 20a and the first metal wiring layer 22a. A third etch stop layer ESL3 may be formed on the second wiring insulating layer 20b and the second metal wiring layer 22b. A fourth etch stop layer ESL4 may be formed on the third wiring insulating layer 20c and the third metal wiring layer 22c. The second etch stop layer ESL2 to the fourth etch stop layer ESL4 may be formed of, for example, silicon nitride. The second etch stop layer ESL2 to the fourth etch stop layer ESL4 might not be formed.

The semiconductor device EX1 may include the through-via (through-silicon-via) 24 formed in the through-via hole 23. The through-via 24 may have a width TW1 in a cross-sectional view (e.g. a width along a horizontal direction). The width TW1 may be a diameter in a plan view. The through-via 24 may extend in a vertical direction from the via connection pad 48, which is any one of the first metal wiring layer 22a to the fourth metal wiring layer 22d, toward the semiconductor substrate 10 and may penetrate the semiconductor substrate 10. The via connection pad 48 may be the fourth metal wiring layer 22d.

The via connection pad 48 may be a capping-type via connection pad formed on an upper surface of the through-via 24. For example, the via connection pad 48 may be a capping-type via connection pad formed on an entirety of the upper surface of the through-via 24. The via connection pad 48 may be formed in the fourth wiring insulating layer 20d. As described above, the via connection pad 48 may include the first capping-type via connection pad 48a formed on the upper surface of the through-via 24, and the second capping-type via connection pad 48b formed on the first capping-type via connection pad 48a.

As illustrated in FIG. 3, the first capping-type via connection pad 48a may be buried in a first via hole 40 in the fourth wiring insulating layer 20d. The first capping-type via connection pad 48a may be buried in a second via hole 42' in the fourth wiring insulating layer 20d. The first via hole 40 and the second via hole 42' may communicate with each other.

A width W1 of the first capping-type via connection pad 48a in a cross-sectional view (e.g. in a horizontal direction) may be greater than the width TW1 of the through-via 24 in a cross-sectional view (e.g. in a horizontal direction). The width W1 may be a diameter in a plan view. A width W2 of the second capping-type via connection pad 48b in a cross-sectional view (e.g. in a horizontal direction) may be greater than the width W1 of the first capping-type via connection pad 48a in a cross-sectional view (e.g. in a horizontal direction). The width W2 may be a diameter in a plan view.

As illustrated in FIG. 4, the first capping-type via connection pad 48a may be buried in the first via hole 40 in the fourth wiring insulating layer 20d. The second capping-type via connection pad 48b may be buried in the second via hole 42 in the fourth wiring insulating layer 20d. The first via hole 40 and the second via hole 42 may communicate with each other.

The width W1 of the first capping-type via connection pad 48a in a cross-sectional view (e.g. in a horizontal direction) may be greater than the width TW1 of the through-via 24 in a cross-sectional view (e.g. in a horizontal direction). A width W3 of the second capping-type via connection pad 48b in a cross-sectional view (e.g. in a horizontal direction) may be greater than the width W1 of the first capping-type via connection pad 48a in a cross-sectional view (e.g. in a horizontal direction). Referring to FIGs. 3 and 4, the width W3 may be greater than the width W2. Referring to FIG. 4, the via connection pad 48 may further include the fourth metal wiring layer 22d at the same horizontal level as the second capping-type via connection pad 48b. The fourth metal wiring layer 22d may be an additional second capping-type via connection pad 48b'.

The semiconductor device EX1 may include the lower pad 36. The lower pad 36 may include the barrier metal layer 32 and the pad metal layer 34. The lower pad 36 may be electrically connected to the through-via 24 on a bottom side of the semiconductor substrate 10. The lower pad 36 may be insulated from the semiconductor substrate 10 by the lower protective insulating layer 28 on the second surface 10b of the semiconductor substrate 10.

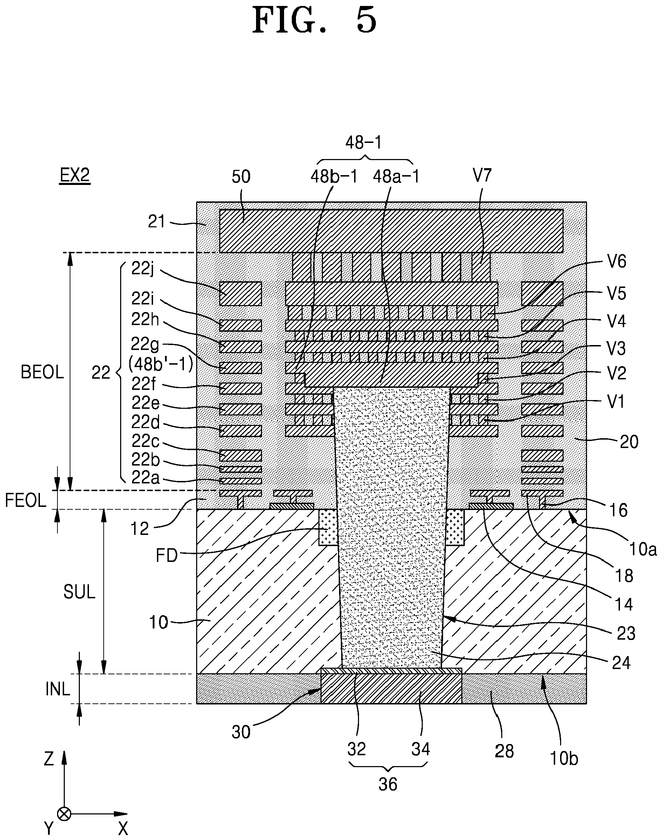

FIG. 5 is a cross-sectional view illustrating a semiconductor device according to an embodiment of the present inventive concept.

For example, a semiconductor device EX2 may be substantially the same as the semiconductor device EX1 of FIG. 1 except that a via connection pad 48-1 is formed in a seventh metal wiring layer 22g. In FIG. 5, descriptions previously given with reference to FIG. 1 are briefly described or omitted.

The semiconductor device EX2 may include a substrate level layer SUL, a front-end level layer FEOL, and a back-end level layer BEOL. The substrate level layer SUL may include a semiconductor substrate 10 having a first surface 10a and a second surface 10b opposite to the first surface 10a. The front-end level layer FEOL may include an integrated circuit layer 14, an interlayer insulating layer 12, a contact plug 16, and an electrode layer 18 formed over the semiconductor substrate 10.

The back-end level layer BEOL may include metal wiring layers 22, a wiring insulating layer 20, and wiring vias V1 to V7. The metal wiring layers 22 may include a first metal wiring layer 22a to a tenth metal wiring layer 22j.

The semiconductor device EX2 may include a through-via (through-silicon-via) 24 and the via connection pad 48-1. The through-via 24 may extend in a vertical direction from the via connection pad 48-1 toward the semiconductor substrate 10 and may penetrate the semiconductor substrate 10. The via connection pad 48-1 may be the seventh metal wiring layer 22g.

The via connection pad 48-1 may be a capping-type via connection pad formed on an upper surface of the through-via 24. For example, the via connection pad 48-1 may be a capping-type via connection pad formed on an entirety of the upper surface of the through-via 24. The via connection pad 48-1 may include a first capping-type via connection pad 48a-1, which is formed on the upper surface of the through-via 24, and a second capping-type via connection pad 48b-1, which is formed on the first capping-type via connection pad 48a-1. For example, the first capping-type via connection pad 48a-1 may be formed on an entirety of the upper surface of the through-via 24, and the second capping-type via connection pad 48b-1 may be formed on an entirety of the first capping-type via connection pad 48a-1. In a cross-sectional view (e.g. in a horizontal direction), a width of the second capping-type via connection pad 48b-1 may be greater than a width of the first capping-type via connection pad 48a-1.

The first capping-type via connection pad 48a-1 and the second capping-type via connection pad 48b-1 may be integrally formed. When the via connection pad 48-1 is configured as a capping-type via connection pad, resistance between the via connection pad 48-1, that is, the seventh metal wiring layer 22g, and the through-via 24 may be reduced.

The semiconductor device EX2 may include a lower pad 36 and an upper pad 50. The lower pad 36 may be electrically connected to the through-via 24 on a bottom side of the semiconductor substrate 10. The lower pad 36 may be insulated by a lower protective insulating layer 28 constituting the insulating level layer INL. The upper pad 50 may be electrically connected to the tenth metal wiring layer 22j through the seventh via V7. The upper pad 50 may be insulated by an upper protective insulating layer 21.

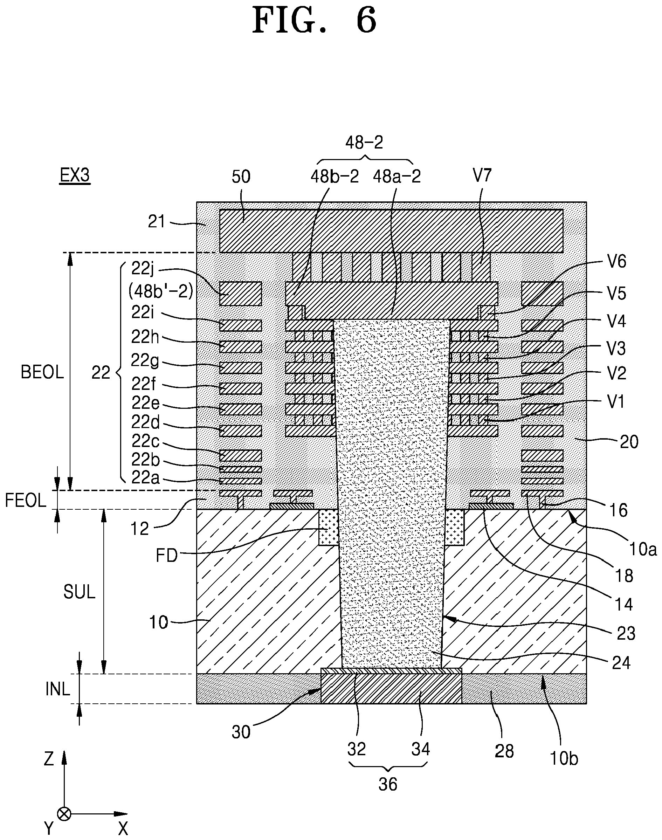

FIG. 6 is a cross-sectional view illustrating a semiconductor device according to an embodiment of the present inventive concept.

For example, a semiconductor device EX3 may be substantially the same as the semiconductor device EX1 of FIG. 1 and the semiconductor device EX2 of FIG. 5, except that a via connection pad 48-2 is formed in the seventh metal wiring layer 22g. In FIG. 6, descriptions previously given with reference to FIGS. 1 and 5 are briefly described or omitted.

The semiconductor device EX3 may include a substrate level layer SUL, a front-end level layer FEOL, and a back-end level layer BEOL. The substrate level layer SUL may include a semiconductor substrate 10 having a first surface 10a and a second surface 10b opposite to the first surface 10a. The front-end level layer FEOL may include an integrated circuit layer 14, an interlayer insulating layer 12, a contact plug 16, and an electrode layer 18 formed over the semiconductor substrate 10.

The back-end level layer BEOL may include metal wiring layers 22, a wiring insulating layer 20, and wiring vias V1 to V7. The metal wiring layers 22 may include a first metal wiring layer 22a to a tenth metal wiring layer 22j.

The semiconductor device EX3 may include a through-via (through-silicon-via) 24 and a via connection pad 48-2. The through-via 24 may extend in a vertical direction from the via connection pad 48-2 toward the semiconductor substrate 10 and may penetrate the semiconductor substrate 10. The via connection pad 48-2 may be the tenth metal wiring layer 22j.

The via connection pad 48-2 may be a capping-type via connection pad formed on an upper surface of the through-via 24. The via connection pad 48-2 may include a first capping-type via connection pad 48a-2, which is formed on the upper surface of the through-via 24, and a second capping-type via connection pad 48b-2, which is formed on the first capping-type via connection pad 48a-2. In a cross sectional view (e.g. in a horizontal direction), a width of the second capping-type via connection pad 48b-2 may be greater than a width of the first capping-type via connection pad 48a-2.

The first capping-type via connection pad 48a-2 and the second capping-type via connection pad 48b-2 may be integrally formed. When the via connection pad 48-2 is configured as a capping-type via connection pad, resistance between the via connection pad 48-2, that is, the tenth metal wiring layer 22j, and the through-via 24 may be reduced.

The semiconductor device EX3 may include a lower pad 36 and an upper pad 50. The lower pad 36 may be electrically connected to the through-via 24 on a bottom side of the semiconductor substrate 10. The lower pad 36 may be insulated by a lower protective insulating layer 28 constituting the insulating level layer INL. The upper pad 50 may be electrically connected to the tenth metal wiring layer 22j through the seventh via V7. The upper pad 50 may be insulated by an upper protective insulating layer 21.

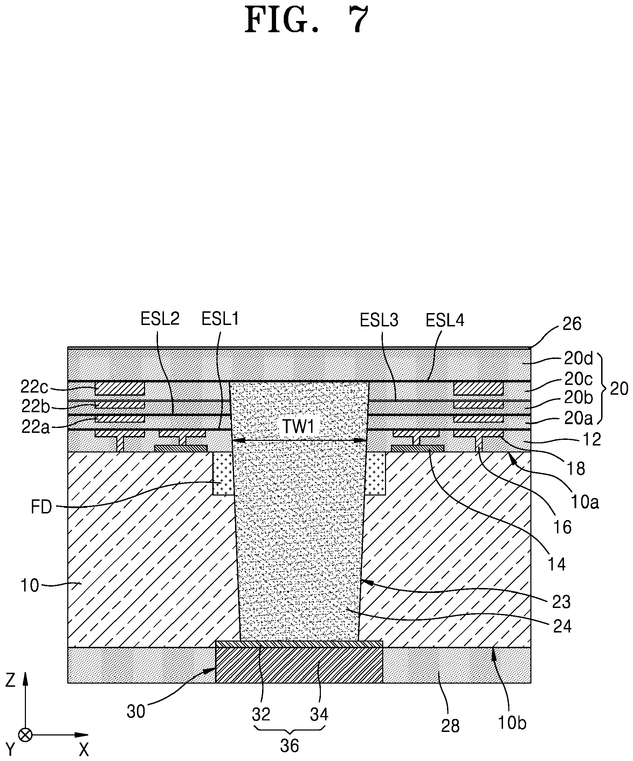

FIGS. 7 to 12 are cross-sectional views illustrating a method of manufacturing a semiconductor device, according to an embodiment of the present inventive concept.

For example, FIGS. 7 to 12 are cross-sectional views illustrating a method of manufacturing the semiconductor device EX1 of FIG. 4. In FIGS. 7 to 12, descriptions previously given with reference to FIGS. 1 to 4 are briefly described or omitted. FIGS. 7 to 12 may include forming a via connection pad 48 by using a dual damascene process.

Referring to FIG. 7, an interlayer insulating layer 12, an integrated circuit layer 14, a contact plug 16, and an electrode layer 18 may be formed over the first surface 10a of the semiconductor substrate 10. The integrated circuit layer 14, the contact plug 16, and the electrode layer 18 may be insulated by the interlayer insulating layer 12.

A first etch stop layer ESL1 may be formed on the electrode layer 18 and the interlayer insulating layer 12. A first wiring insulating layer 20a and a first metal wiring layer 22a may be formed on the first etch stop layer ESL1. The first metal wiring layer 22a may be formed in the first wiring insulating layer 20a. A second etch stop layer ESL2 may be formed on the first wiring insulating layer 20a and the first metal wiring layer 22a.

A second wiring insulating layer 20b and a second metal wiring layer 22b may be formed on the second etch stop layer ESL2. The second metal wiring layer 22b may be formed in the second wiring insulating layer 20b. A third etch stop layer ESL3 may be formed on the second wiring insulating layer 20b and the second metal wiring layer 22b.

A third wiring insulating layer 20c and a third metal wiring layer 22c may be formed on the third etch stop layer ESL3. The third metal wiring layer 22c may be formed in the third wiring insulating layer 20c. A through-via hole 23 may be formed to extend in a vertical direction from an upper surface of the third wiring insulating layer 20c toward the semiconductor substrate 10 and to penetrate the semiconductor substrate 10. The through-via hole 23 may penetrate an inactive region FD. A through-via 24 may be buried in the through-via hole 23. The through-via 24 may have a width TW1 in a cross-section view.

A fourth etch stop layer ESL4 may be formed on the third wiring insulating layer 20c, the third metal wiring layer 22c, and the through-via 24. A fourth wiring insulating layer 20d may be formed on the fourth etch stop layer ESL4. Through this process, wiring insulating layers 20 and metal wiring layers 22 in FIG. 1 may be formed.

The wiring insulating layers 20 may include the first wiring insulating layer 20a to the fourth wiring insulating layer 20d. The metal wiring layers 22 in FIG. 1 may include the first metal wiring layer 22a to the third metal wiring layer 22c. The first metal wiring layer 22a to the third metal wiring layer 22c may be electrically connected to each other.

Subsequently, a hard mask layer 26 may be formed on the fourth wiring insulating layer 20d. The hard mask layer 26 may be any material having a sufficient etch selectivity with respect to the fourth wiring insulating layer 20d, and the present inventive concept is not limited thereto. For example, the hard mask layer 26 may be formed of a carbon-based material.

A lower pad 36 and a lower protective insulating layer 28 may be formed on the second surface 10b of the semiconductor substrate 10. A barrier metal layer 32 and a pad metal layer 34 may be formed in a via exposure hole 30 that exposes the through-via 24 and may be in the lower protective insulating layer 28. For example, the via exposure hole 30 may be formed in a portion of the semiconductor substrate 10 and the lower protective insulating layer 28. The lower pad 36 may be electrically connected to the through-via 24 at a bottom side of the semiconductor substrate 10. The lower pad 36 may be insulated from the semiconductor substrate 10 by the lower protective insulating layer 28 on the second surface 10b of the semiconductor substrate 10.

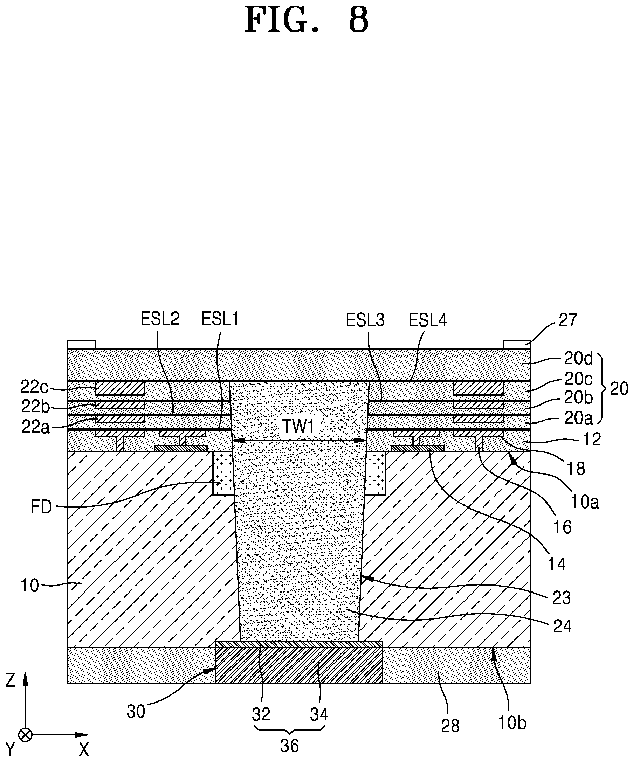

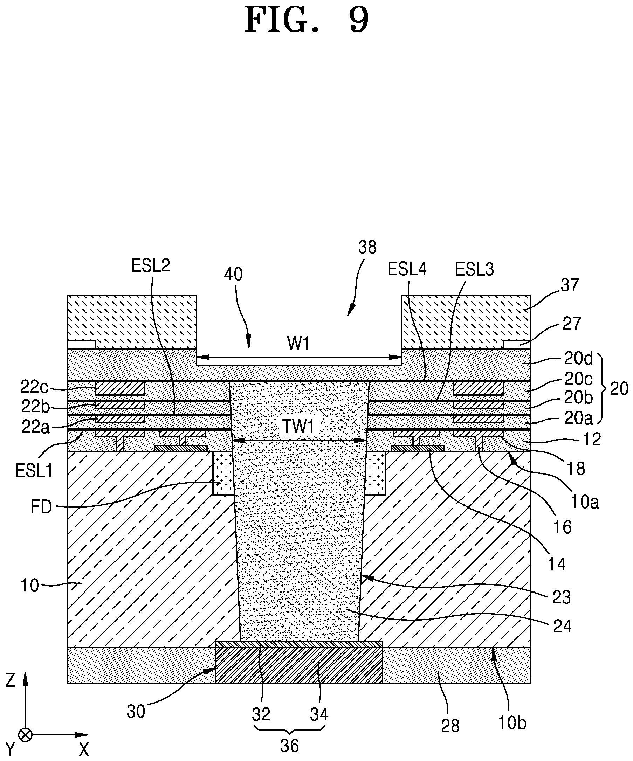

Referring to FIGS. 8 and 9, a hard mask pattern 27 may be formed by patterning the hard mask layer 26 in FIG. 7 as illustrated in FIG. 8. The hard mask pattern 27 may expose the fourth wiring insulating layer 20d that is formed over the third metal wiring layer 22c and the through-via 24.

As illustrated in FIG. 9, a photoresist pattern 37 having a hole 38 exposing the fourth wiring insulating layer 20d above the through-via 24 may be formed on the hard mask pattern 27 and the fourth wiring insulating layer 20d. Subsequently, a first via hole 40 may be formed by partially etching the fourth wire insulating layer 20d by using the photoresist pattern 37 as an etch mask.

The first via hole 40 may be aligned with the hole 38. The first via hole 40 may be formed in a partial region of the fourth wiring insulating layer 20d. The first via hole 40 may have a width W1. The width W1 of the first via hole 40 may be larger than a width TW1 of the through-via 24 in a cross-sectional view.

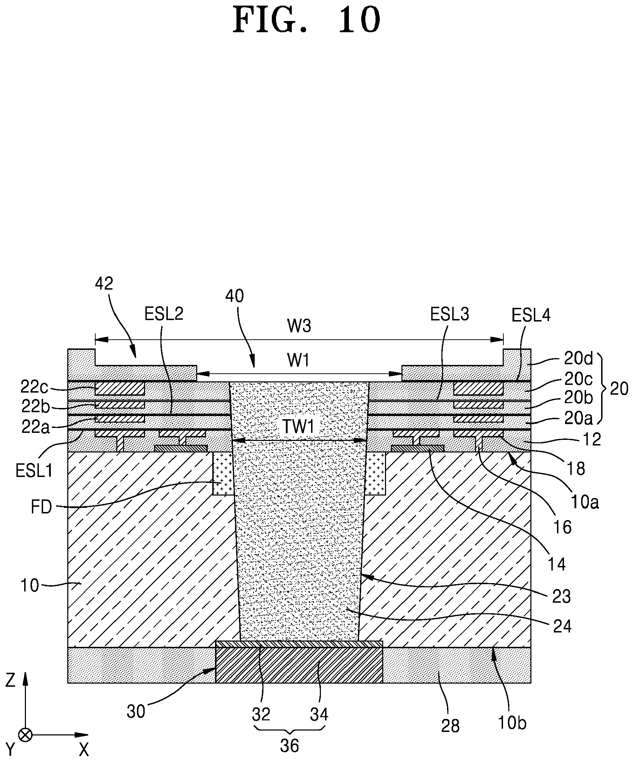

Referring to FIG. 10, after the photoresist pattern 37 in FIG. 9 is removed, a second via hole 42 may be formed by partially etching the fourth wiring insulating layer 20d by using the hard mask pattern 27 as an etch mask. The second via hole 42 may communicate with the first via hole 40. A width W3 of the second via hole 42 may be greater than the width W1 of the first via hole 40 in a cross-sectional view. During the formation of the second via hole 42, the fourth wiring insulating layer 20d in the region of the first via hole 40 may be further etched in order to expose an upper surface of the through-via 24.

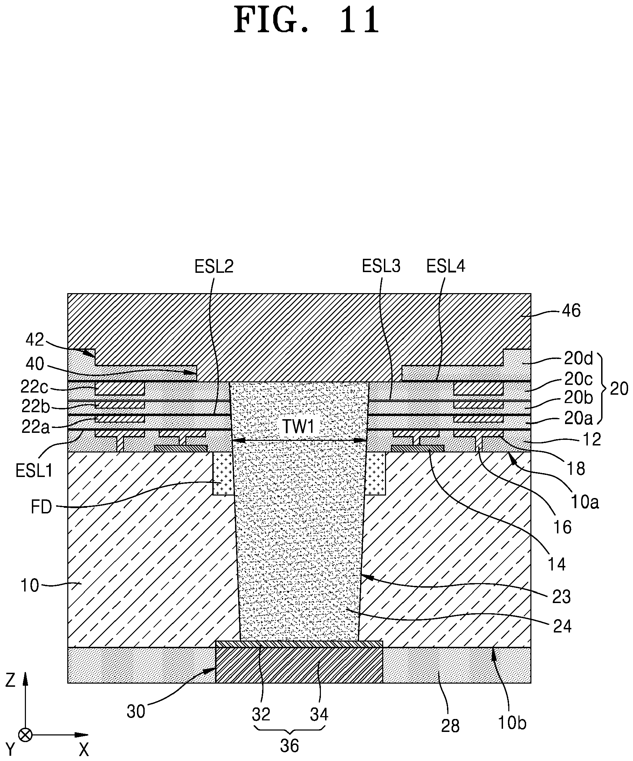

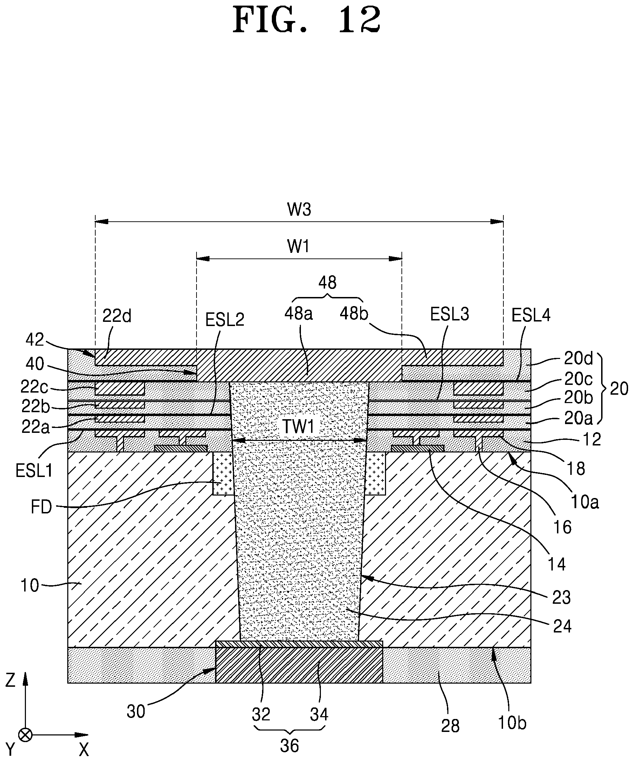

Referring to FIGS. 11 and 12, a via connection pad metal layer 46 may be formed on the first via hole 40, the second via hole 42, and the fourth wiring insulating layer 20d as illustrated in FIG. 11. The via connection pad metal layer 46 may be formed on the fourth wiring insulating layer 20d by filling the first via hole 40 and the second via hole 42. The via connection pad metal layer 46 may be formed on the through-via 24.

As illustrated in FIG. 12, a via connection pad 48 may be formed by planarizing (e.g. through chemical-mechanical polishing) the via connection pad metal layer 46 (e.g. to lower the upper surface of the via connection pad metal layer 46 to be level with the upper surface of the fourth wiring insulating layer 20d). The via connection pad 48 may be a capping-type via connection pad formed on an upper surface of the through-via 24. The via connection pad 48 may be the fourth metal wiring layer 22d.

As described above, the via connection pad 48 may include a first capping-type via connection pad 48a, which is formed on the upper surface of the through-via 24, and a second capping-type via connection pad 48b, which is formed entirely on the first capping-type via connection pad 48a. In cross-sectional view, the width W3 of the second capping-type via connection pad 48b may be greater than the width W1 of the first capping-type via connection pad 48a. The first capping-type via connection pad 48a and the second capping-type via connection pad 48b may be integrally formed.

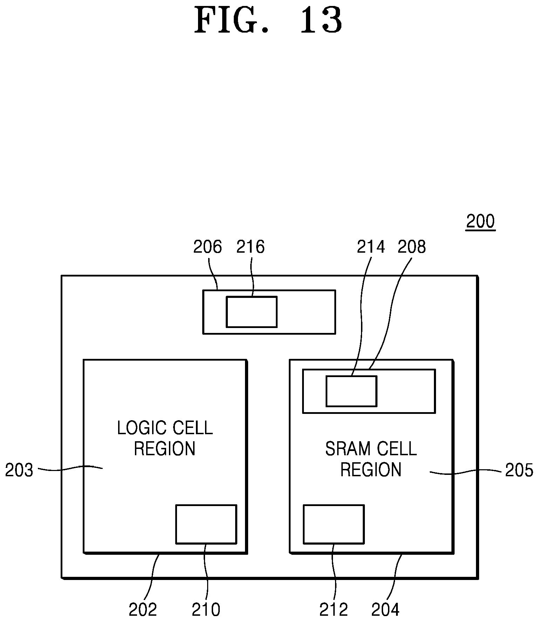

FIG. 13 is a block diagram illustrating a configuration of a semiconductor chip including a semiconductor device according to an embodiment of the present inventive concept.

A semiconductor chip 200 may include a logic region 202, an SRAM region 204, and an input/output region 206. The semiconductor chip 200 may include the semiconductor devices EX1 to EX3 according to embodiments of the present inventive concept. The logic region 202 may include a logic cell region 203. The SRAM region 204 may include an SRAM cell region 205 and an SRAM peripheral circuit region 208.

A first transistor 210 may be in the logic cell region 203, and a second transistor 212 may be in the SRAM cell region 205. A third transistor 214 may be in the SRAM peripheral circuit region 208, and a fourth transistor 216 may be in the input/output region 206.

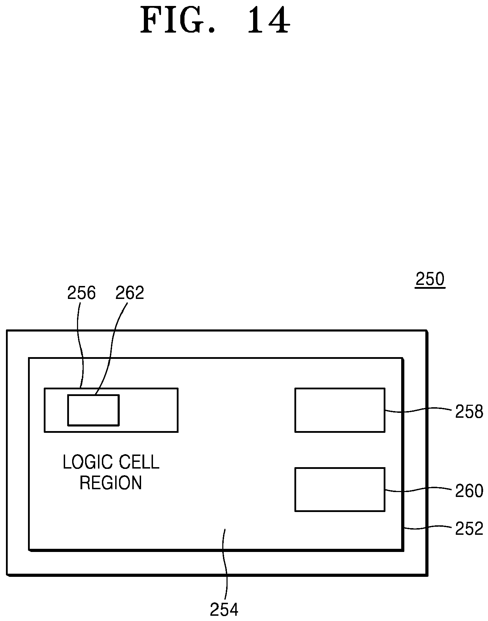

FIG. 14 is a block diagram illustrating a configuration of a semiconductor chip including a semiconductor device according to an embodiment of the present inventive concept.

A semiconductor chip 250 may include a logic region 252. The semiconductor chip 250 may include the semiconductor devices EX1 to EX3 according to embodiments of the present inventive concept. The logic region 252 may include a logic cell region 254 and an input/output region 256. A first transistor 258 and a second transistor 260 may be in the logic cell region 254. The first transistor 258 and the second transistor 260 may have different conductivity types from each other. A third transistor 262 may be in the input/output region 256.

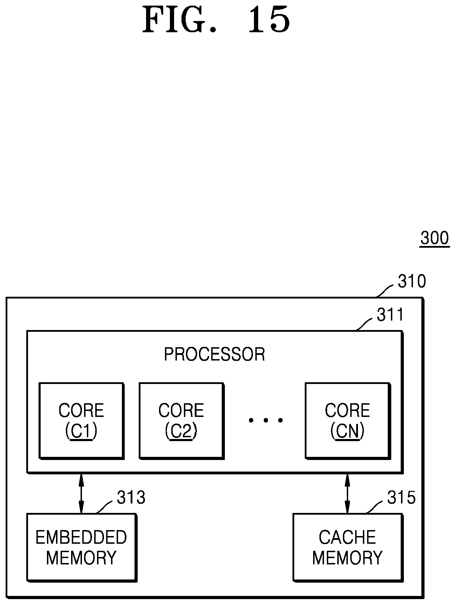

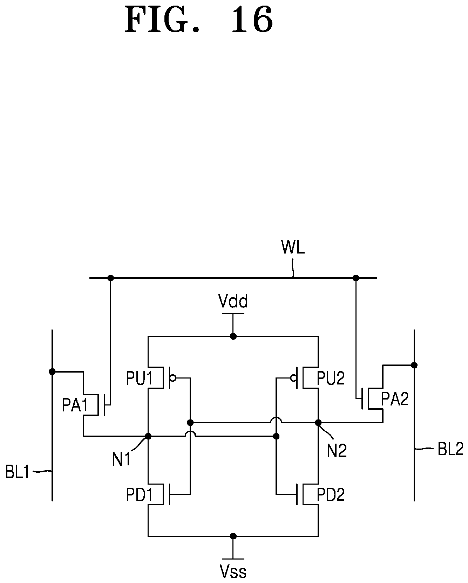

FIG. 15 is a block diagram illustrating a configuration of a semiconductor package including a semiconductor device according to an embodiment of the present inventive concept, and FIG. 16 is a circuit diagram of an SRAM cell included in a semiconductor device according to an embodiment of the present inventive concept.

Referring to FIG. 15, a semiconductor package 300 may include a system on chip 310. The system on chip 310 may include a processor 311, an embedded memory 313, and a cache memory 315. The processor 311 may include one or more processor cores C1 to CN. The processor cores C1 to CN may process data and signals. The processor cores C1 to CN may include the semiconductor devices EX1 to EX3 according to embodiments of the present inventive concept.

The semiconductor package 300 may perform a unique function thereof by using the processed data and signals. For example, the processor 311 may include an application processor. The embedded memory 313 may exchange first data with the processor 311. The first data may be data processed or data that is to be processed by the processor cores C1 to CN. The embedded memory 313 may manage the first data. For example, the embedded memory 313 may buffer the first data. The embedded memory 313 may operate as a buffer memory or a working memory of the processor 311.

The embedded memory 313 may include SRAM. The SRAM may operate at a higher speed than DRAM. When the SRAM is embedded in the system on chip 310, the semiconductor package 300 having a small size and operating at a high speed may be implemented. Furthermore, when the SRAM is embedded in the system on chip 310, consumption of active power of the semiconductor package 300 may be reduced.

For example, the SRAM may include the semiconductor devices EX1 to EX3 according to embodiments of the present inventive concept. The cache memory 315 may be mounted on the system on chip 310 together with the processor cores C1 to CN. The cache memory 315 may store cache data. The cache data may be used by the processor cores C1 to Cn. The cache memory 315 may have a small storage capacity but may operate at a very high speed.

For example, the cache memory 315 may include SRAM including the semiconductor devices EX1 to EX3 according to embodiments of the present inventive concept. When the cache memory 315 is used, the number of times and time for the processor 311 to access the embedded memory 1213 may be reduced. Accordingly, when the cache memory 315 is used, an operating speed of the semiconductor package 300 may be increased. For ease of understanding, the cache memory 315 is illustrated as a separate component from the processor 311. However, the cache memory 315 may be included in the processor 311.

Referring to FIG. 16, an SRAM cell may be implemented by using the semiconductor devices EX1 to EX3 according to embodiments of the present inventive concept. For example, the SRAM cell may be applied to the embedded memory 313 and/or the cache memory 315 described above with reference to FIG. 15. The SRAM cell may include a first pull-up transistor PU1, a first pull-down transistor PD1, a second pull-up transistor PU2, a second pull-down transistor PD2, a first access transistor PA1, and a second access transistor PA2.

The first pull-up transistor PU1 and the second pull-up transistor PU2 may be P-type MOS transistors, while the first pull-down transistor PD1, the second pull-down transistor PD2, the first access transistor PA1, and the second access transistor PA2 may be N-type MOS transistors. The first pull-up transistor PU1 and the first pull-down transistor PD1 may constitute a first inverter. Gate electrodes (gates) of the first pull-up transistor PU1 and the first pull-down transistor PD1, which are connected to each other, may correspond to an input terminal of the first inverter, and a first node N1 may correspond to an output terminal of the first inverter.

The second pull-up transistor PU2 and the second pull-down transistor PD2 may constitute a second inverter. Gate electrodes (gates) of the second pull-up transistor PU2 and the second pull-down transistor PD2, which are connected to each other, may correspond to an input terminal of the second inverter, and a second node N2 may correspond to an output terminal of the second inverter.

The first and second inverters may be combined to form a latch structure. The gate electrodes of the first pull-up transistor PU1 and the first pull-down transistor PD1 may be electrically connected to the second node N2, and the gate electrodes of the second pull-up transistor PU2 and the second pull-down transistor PD2 may be electrically connected to the first node N1.

A first source/drain of the first access transistor PA1 may be connected to the first node N1, and a second source/drain of the first access transistor PA1 may be connected to a first bit line BL1. The first source/drain of the second access transistor PA2 may be connected to the second node N2, and the second source/drain of the second access transistor PA2 may be connected to the second bit line BL2.

The gate electrodes of the first access transistor PA1 and the second access transistor PA2 may be electrically connected to a word line WL. Accordingly, an SRAM cell may be implemented by using the semiconductor devices EX1 to EX3 according to embodiments of the present inventive concept.

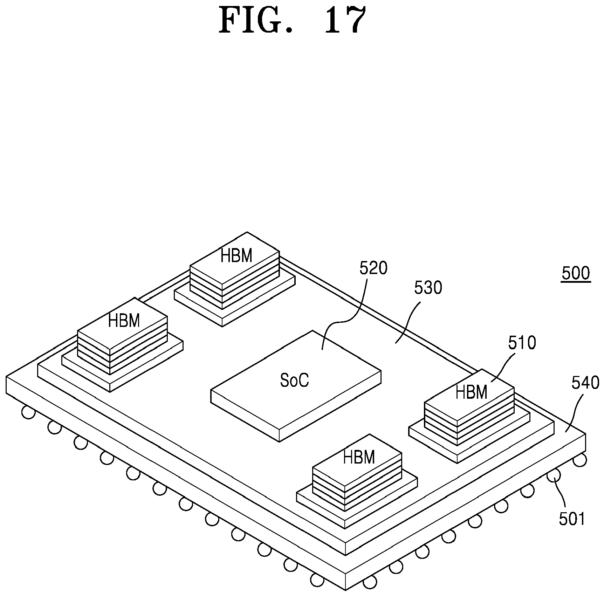

FIG. 17 is a view illustrating a semiconductor package including a semiconductor device, according to an embodiment of the present inventive concept.

A semiconductor package 500 may include a plurality of stacked memory devices 510 and a system on chip 520. The plurality of stacked memory devices 510 and the system on chip 520 may be stacked on an interposer 530, and the interposer 530 may be stacked on a package substrate 540. The semiconductor package 500 may transmit and receive signals to and from other external packages or electronic devices through solder balls 501 that are attached to a lower portion of the package substrate 540.

Each of the plurality of stacked memory devices 510 may be implemented based on an HBM (High Bandwidth Memory) standard. However, the present inventive concept is not limited thereto, and each of the plurality of stacked memory devices 510 may be implemented based on a graphics double data rate (GDDR), a hybrid memory cube (HMC), or a wide input/output (I/O) standard. Each of the plurality of stacked memory devices 510 may include the semiconductor devices EX1 to EX3 according to embodiments of the present inventive concept.

The system on chip 520 may perform a specialized operation by including at least one of, for example, a central processing unit (CPU), an application processor (AP), a graphics processing unit (GPU), a neural processing unit (NPU), a tensor processing unit (TPU), a vision processing unit (VPU), an image signal processor (ISP), and a digital signal processor (DSP).

The system on chip 520 may include the processors described above and a plurality of memory controllers for controlling the plurality of stacked memory devices 510. The system on chip 520 may transmit and receive signals to and from the plurality of stacked memory devices 510 through the plurality of memory controllers.

The description refers to relative positions and directions, such as front, back, upper, lower, vertical, horizontal, etc. It will be appreciated that these terms are relative terms, and need not indicate any particular orientation of the semiconductor device during use.

While the present inventive concept has been described with reference to example embodiments thereof, it will be understood by those of ordinary skill in the art that various changes in form and details may be made thereto without departing from the scope of the present inventive concept.

Embodiments are set out in the following clauses:
1. A semiconductor device comprising:
   a semiconductor substrate;
   an integrated circuit layer disposed on the semiconductor substrate;
   a first metal wiring layer to an n-th metal wiring layer sequentially disposed on the semiconductor substrate and the integrated circuit layer, wherein n is a positive integer;
   a plurality of wiring vias connecting the first to n-th metal wiring layers to each other; and
   a through-via extending in a vertical direction from a via connection pad, which is any one of the first metal wiring layer to the n-th metal wiring layer, toward the semiconductor substrate and penetrating the semiconductor substrate,
   wherein the via connection pad is a capping-type via connection pad formed on an upper surface of the through-via.
2. The semiconductor device of clause 1, wherein the via connection pad includes a first capping-type via connection pad and a second capping-type via connection pad, wherein the first capping-type via connection pad is formed on an entirety of the upper surface of the through-via, and the second capping-type via connection pad is formed on the first capping-type via connection pad.
3. The semiconductor device of clause 2, wherein
   the first capping-type via connection pad and the second capping-type via connection pad are integrally formed,
   a width of the first capping-type via connection pad is greater than a width of the through-via, and
   a width of the second capping-type via connection pad is greater than a width of the first capping-type via connection pad.
4. The semiconductor device of any preceding clause, wherein the via connection pad includes a first capping-type via connection pad and a second capping-type via connection pad, wherein the first capping-type via connection pad includes an octagonal shape that is formed on an upper surface of the through-via and at least partially surrounds the through-via, and the second capping-type via connection pad includes an octagonal shape that is formed on an upper surface of the first capping-type via connection pad and at least partially surrounds the first capping-type via connection pad.
5. The semiconductor device of clause 4, wherein the via connection pad further comprises the n-th metal wiring layer, among the first metal wiring layer to the n-th metal wiring layer, at a same horizontal level as the second capping-type via connection pad.
6. The semiconductor device of any preceding clause, wherein
   the n-th metal wiring layer, among the first metal wiring layer to the n-th metal wiring layer, at a same horizontal level as the via connection pad is around the via connection pad, and
   the n-th metal wiring layer includes a mesh pattern.
7. The semiconductor device of any preceding clause, wherein
   an upper pad is electrically connected to the n-th metal wiring layer and is formed on the n-th metal wiring layer that is an uppermost layer among the first metal wiring layer to the n-th metal wiring layer, and
   a lower pad electrically connected to the through-via and is formed on a lower surface of the semiconductor substrate.
8. A semiconductor device comprising:
   a semiconductor substrate having a first surface and a second surface opposite to the first surface;
   a front-end level layer including an integrated circuit layer that is disposed on the first surface of the semiconductor substrate;
   a back-end level layer including a first metal wiring layer to an n-th metal wiring layer and a plurality of wiring vias respectively connecting the first metal wiring layer to the n-th metal wiring layer to each other, wherein n is a positive integer, and the first metal wiring layer to the n-th metal wiring layer are sequentially disposed on the front-end level layer; and
   a through-via extending in a vertical direction from a via connection pad, which is any one of the first metal wiring layer to the n-th metal wiring layer, toward the semiconductor substrate and penetrating the back-end level layer, the front-end level layer, and the first surface and the second surface of the semiconductor substrate,
   wherein the via connection pad includes a first capping-type via connection pad and a second capping-type via connection pad, wherein the first capping-type via connection pad is formed on an upper surface of the through-via, and the second capping-type via connection pad is formed on the first capping-type via connection pad and has a width greater than a width of the first capping-type via connection pad.
9. The semiconductor device of clause 8, wherein
   the first capping-type via connection pad is formed on an entirety of the upper surface of the through-via and has an octagonal shape at least partially surrounding the through-via, and
   the second capping-type via connection pad is formed on an entirety of an upper surface of the first capping-type via connection pad and has an octagonal shape at least partially surrounding the first capping-type via connection pad.
10. The semiconductor device of clause 8 or clause 9, wherein the via connection pad further comprises the n-th metal wiring layer, among the first metal wiring layer to the n-th metal wiring layer, at a same horizontal level as the second capping-type via connection pad.
11. The semiconductor device of any of clauses 8-10, wherein
   the n-th metal wiring layer, among the first metal wiring layer to the n-th metal wiring layer, at a same horizontal level as the second capping-type via connection pad is around the second capping-type via connection pad, and
   the n-th metal wiring layer includes a mesh pattern.
12. The semiconductor device of any of clauses 8-11, wherein the back-end level layer comprises:
   the first metal wiring layer to the n-th metal wiring layer;
   a wiring insulating layer disposed between the first metal wiring layer to the n-th metal wiring layer; and
   the plurality of wiring vias connecting the first metal wiring layer to the n-th metal wiring layer to each other in the wiring insulating layer.
13. A semiconductor device comprising:
   a semiconductor substrate;
   a front-end level layer including an integrated circuit layer disposed on the semiconductor substrate, an interlayer insulating layer disposed on the integrated circuit layer, and a contact plug and an electrode layer electrically connected to the integrated circuit layer within the interlayer insulating layer;
   a back-end level layer including a first metal wiring layer to an n-th metal wiring layer, which are electrically connected to the contact plug and the electrode layer, over the front-end level layer, a plurality of wiring insulating layers disposed between the first metal wiring layer to the n-th metal wiring layer, and a plurality of wiring vias disposed between the first metal wiring layer to the n-th metal wiring layers within the wiring insulating layers, wherein n is a positive integer; and
   a through-via extending in a vertical direction from a via connection pad, which is any one of the first metal wiring layer to the n-th metal wiring layer, toward the semiconductor substrate and penetrating the plurality of wiring insulating layers, the interlayer insulating layer, and the semiconductor substrate,
   wherein the via connection pad includes a first capping-type via connection pad and a second capping-type via connection pad, wherein the first capping-type via connection pad covers an upper surface of the through-via and has an octagonal shape, and the second capping-type via connection pad is formed on the first capping-type via connection pad and has an octagon shape at least partially surrounding the first capping-type via connection pad.
14. The semiconductor device of clause 13, wherein the via connection pad further comprises the n-th metal wiring layer, among the first metal wiring layer to the n-th metal wiring layer, at a same horizontal level as the second capping-type via connection pad.
15. The semiconductor device of clause 13 or clause 14, wherein
   the n-th metal wiring layer, among the first metal wiring layer to the n-th metal wiring layer, at a same horizontal level as the second capping-type via connection pad is around the second capping-type via connection pad, and
   the n-th metal wiring layer includes a mesh pattern.

## Claims

1. A semiconductor device comprising:
a semiconductor substrate;
an integrated circuit layer disposed on the semiconductor substrate;
a first metal wiring layer to an n-th metal wiring layer sequentially disposed on the semiconductor substrate and the integrated circuit layer, wherein n is a positive integer;
a plurality of wiring vias connecting the first to n-th metal wiring layers to each other; and
a through-via extending in a vertical direction from a via connection pad, which is any one of the first metal wiring layer to the n-th metal wiring layer, toward the semiconductor substrate and penetrating the semiconductor substrate,
wherein the via connection pad is a capping-type via connection pad formed on an upper surface of the through-via.

2. The semiconductor device of claim 1, wherein the via connection pad includes a first capping-type via connection pad and a second capping-type via connection pad, wherein the first capping-type via connection pad is formed on an entirety of the upper surface of the through-via, and the second capping-type via connection pad is formed on the first capping-type via connection pad.

3. The semiconductor device of claim 2, wherein
the first capping-type via connection pad and the second capping-type via connection pad are integrally formed,
a width of the first capping-type via connection pad is greater than a width of the through-via, and
a width of the second capping-type via connection pad is greater than a width of the first capping-type via connection pad.

4. The semiconductor device of claim 1, wherein the via connection pad includes a first capping-type via connection pad and a second capping-type via connection pad, wherein the first capping-type via connection pad includes an octagonal shape that is formed on an upper surface of the through-via and at least partially surrounds the through-via, and the second capping-type via connection pad includes an octagonal shape that is formed on an upper surface of the first capping-type via connection pad and at least partially surrounds the first capping-type via connection pad.

5. The semiconductor device of claim 4, wherein the via connection pad further comprises the n-th metal wiring layer, among the first metal wiring layer to the n-th metal wiring layer, at a same horizontal level as the second capping-type via connection pad.

6. The semiconductor device of any preceding claim, wherein
the n-th metal wiring layer, among the first metal wiring layer to the n-th metal wiring layer, is at a same horizontal level as the via connection pad and is around the via connection pad, and
the n-th metal wiring layer includes a mesh pattern.

7. The semiconductor device of any preceding claim, wherein
an upper pad is electrically connected to the n-th metal wiring layer and is formed on the n-th metal wiring layer that is an uppermost layer among the first metal wiring layer to the n-th metal wiring layer, and
a lower pad is electrically connected to the through-via and is formed on a lower surface of the semiconductor substrate.

8. The semiconductor device of claim 1, wherein:
the semiconductor substrate has a first surface and a second surface opposite to the first surface;
the integrated circuit layer is part of a front-end level layer and is disposed on the first surface of the semiconductor substrate;
the first metal wiring layer to the n-th metal wiring layer and the plurality of wiring vias form part of a back-end level layer, and the first metal wiring layer to the n-th metal wiring layer are sequentially disposed on the front-end level layer; and
the through-via penetrates the back-end level layer, the front-end level layer, and the first surface and the second surface of the semiconductor substrate,
wherein the via connection pad includes a first capping-type via connection pad and a second capping-type via connection pad, wherein the first capping-type via connection pad is formed on the upper surface of the through-via, and the second capping-type via connection pad is formed on the first capping-type via connection pad and has a width greater than a width of the first capping-type via connection pad.

9. The semiconductor device of claim 8, wherein
the first capping-type via connection pad is formed on an entirety of the upper surface of the through-via and has an octagonal shape at least partially surrounding the through-via, and
the second capping-type via connection pad is formed on an entirety of an upper surface of the first capping-type via connection pad and has an octagonal shape at least partially surrounding the first capping-type via connection pad.

10. The semiconductor device of claim 8 or claim 9, wherein the via connection pad further comprises the n-th metal wiring layer, among the first metal wiring layer to the n-th metal wiring layer, at a same horizontal level as the second capping-type via connection pad.

11. The semiconductor device of any of claims 8-10, wherein
the n-th metal wiring layer, among the first metal wiring layer to the n-th metal wiring layer, is at a same horizontal level as the second capping-type via connection pad and is around the second capping-type via connection pad, and
the n-th metal wiring layer includes a mesh pattern.

12. The semiconductor device of any of claims 8-11, wherein the back-end level layer comprises:
the first metal wiring layer to the n-th metal wiring layer;
a wiring insulating layer disposed between the first metal wiring layer to the n-th metal wiring layer; and
the plurality of wiring vias connecting the first metal wiring layer to the n-th metal wiring layer to each other in the wiring insulating layer.

13. The semiconductor device of claim 1, further comprising:
a front-end level layer including the integrated circuit layer, an interlayer insulating layer disposed on the integrated circuit layer, and a contact plug and an electrode layer electrically connected to the integrated circuit layer within the interlayer insulating layer; and
a back-end level layer including the first metal wiring layer to an n-th metal wiring layer, which are electrically connected to the contact plug and the electrode layer, over the front-end level layer, a plurality of wiring insulating layers disposed between the first metal wiring layer to the n-th metal wiring layer, and the plurality of wiring vias disposed between the first metal wiring layer to the n-th metal wiring layers within the wiring insulating layers,
wherein the through-via penetrates the plurality of wiring insulating layers and the interlayer insulating layer, and
wherein the via connection pad includes a first capping-type via connection pad and a second capping-type via connection pad, wherein the first capping-type via connection pad covers an upper surface of the through-via and has an octagonal shape, and the second capping-type via connection pad is formed on the first capping-type via connection pad and has an octagonal shape at least partially surrounding the first capping-type via connection pad.

14. The semiconductor device of claim 13, wherein the via connection pad further comprises the n-th metal wiring layer, among the first metal wiring layer to the n-th metal wiring layer, at a same horizontal level as the second capping-type via connection pad.

15. The semiconductor device of claim 13 or claim 14, wherein
the n-th metal wiring layer, among the first metal wiring layer to the n-th metal wiring layer, is at a same horizontal level as the second capping-type via connection pad and is around the second capping-type via connection pad, and
the n-th metal wiring layer includes a mesh pattern.
